# EUROPEAN PATENT APPLICATION

(11) **EP 4 579 727 A2**
(43) Date of publication of application: **02.07.2025**
(21) Application number: 24219989.1
(22) Date of filing: 13.12.2024
(51) Int. Cl.: H01L 23/00

(54) **CHIP BONDING APPARATUS FOR SEMICONDUCTOR PACKAGING AND SEMICONDUCTOR PACKAGING METHOD USING THE SAME**

(30) Priority: 28.12.2023 KR 20230193788; 14.10.2024 KR 20240139203
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a chip bonding apparatus for semiconductor packaging and a semiconductor packaging method using the same. The chip bonding apparatus may include a bonding head, wherein the bonding head may include a plurality of chip holding units, each of which is configured to individually hold a chip, and the bonding head may be configured to adjust the interval between the plurality of chip holding units. The chip bonding apparatus may be configured to bond a plurality of chips to a given target surface at controlled intervals using the plurality of chip holding units according to a multi-chip bonding method. The semiconductor packaging method may include bonding chips to a target surface of a carrier substrate at controlled intervals using the plurality of chip holding units according to the multi-chip bonding method.

## Description

### BACKGROUND OF THE INVENTION

### 1. Field of the invention

The present invention relates to technology, apparatuses, and methods related to semiconductor packaging, and more particularly to a chip bonding apparatus for semiconductor packaging and a semiconductor packaging method using the same.

### 2. Description of the Related Art

A semiconductor process may be divided into a front-end process of manufacturing a wafer and engraving a circuit and a back-end process of packaging a chip. As semiconductor miniaturization technology approaches its limits, importance of the back-end process is further increasing.

A conventional semiconductor packaging method is to package individual dies (i.e., chips) one by one after dicing of a wafer. This method suffers from significant lower productivity due to the need to handle each individual die one by one and the small number of chips that can be packaged at once. In order to overcome this problem, a fan-in wafer level package (FIWLP) method of performing first a package process in a wafer state and then performing dicing has been developed. The FIWLP method has the advantage that all processes prior to dicing are performed in a single wafer state, whereby process connectivity is good and existing process equipment may be utilized without change. However, defective chips are packaged together with functional chips, resulting in economic losses, and there is limitation in increasing the number of input and output terminals because the input and output terminals are formed only in the area of the chip.

In order to overcome the limitation and problem of the FIWLP method, fan-out wafer level package (FOWLP) and fan-out panel level package (FOPLP) methods capable of forming input and output terminals in an area greater than the area of a chip have been proposed. The FOWLP method differs from the FOPLP method in that the FOWLP method uses a circular wafer as a carrier substrate while the FOPLP method uses a quadrangular carrier substrate (panel). Both the FOWLP and FOPLP methods have the advantage that wires and solder balls can be formed on a larger area than the chip, whereby the number of input and output terminals can be increased as desired. In addition, chip reliability may be improved because the chip protection area is increased, and unit cost may be reduced because defective chips (dies) do not need to be packaged together. Furthermore, the FOWLP and FOPLP methods have the advantage of enabling integrated packaging (heterogeneous chip packaging) that integrates or connects heterogeneous chips, which is important for advanced packaging technologies.

However, in the FOWLP and FOPLP methods, there may be process difficulties in repositioning a plurality of chips (dies) divided from a wafer through a dicing process on the carrier substrate. The chips must be precisely disposed on (bonded to) the carrier substrate according to the interval determined by the package design (package size), and the rearranged chips must not move or be damaged during the process. For precision processes, a single chip bonding method in which chips (dies) are transferred one by one and bonded to the carrier substrate is applied to the current process equipment, which requires significant time for bonding a large number of chips and increases equipment input and equipment operation time. Furthermore, in order to perform flip chip type chip bonding, the chips need to be flipped upside down and bonded, which further increases time consumption and process difficulties.

### SUMMARY OF THE INVENTION

It is an object of the present invention to provide a chip bonding apparatus capable of bonding a plurality of chips to a given target surface at controlled intervals according to a multi-chip bonding method, thereby significantly improving process efficiency while securing precision in semiconductor packaging.

It is another object of the present invention to provide a semiconductor packaging method using the chip bonding apparatus, to which the multi-chip bonding method is applied.

Objects of the present invention are not limited to the aforementioned objects, and other unmentioned objects will be understood by those skilled in the art based on the following description.

In accordance with one aspect of the present invention, the above and other objects can be accomplished by the provision of a chip bonding apparatus for semiconductor packaging, the chip bonding apparatus including a bonding head, wherein the bonding head includes a plurality of chip holding units, each of which is configured to individually hold a chip, the bonding head being configured to adjust the interval between the plurality of chip holding units, and the chip bonding apparatus is configured to bond a plurality of chips to a given target surface at controlled intervals using the plurality of chip holding units according to a multi-chip bonding method.

The plurality of chip holding units may include a first group of chip holding units arranged in line in a first direction, and the bonding head may be configured to move at least one of the first group of chip holding units in a direction parallel to the first direction.

The plurality of chip holding units may be arranged to form a plurality of rows in a first direction and a plurality of columns in a second direction perpendicular to the first direction, and the bonding head may be configured to move at least one of the plurality of chip holding units in a direction parallel to the first direction and to move at least one of the plurality of chip holding units in a direction parallel to the second direction.

The bonding head may include at least one linear motor, and the chip bonding apparatus may be configured to adjust the interval between the plurality of chip holding units using the at least one linear motor.

The bonding head may include a rod type member extending in a first direction and a first group of chip holding units coupled to the rod type member, at least one of the first group of chip holding units being configured to be linearly movable in a direction parallel to the first direction.

The bonding head may include first and second rod type members extending side by side in a first direction and spaced apart from each other in a second direction perpendicular to the first direction, the interval between the first and second rod type members being adjusted in the second direction, a first group of chip holding units coupled to the first rod type member, at least one of the first group of chip holding units being configured to be linearly movable along the first rod type member in a direction parallel to the first direction, and a second group of chip holding units coupled to the second rod type member, at least one of the second group of chip holding units being configured to be linearly movable along the second rod type member in a direction parallel to the first direction.

The chip bonding apparatus may be applied to flip chip type chip bonding in a fan-out wafer level package (FOWLP) or fan-out panel level package (FOPLP) type semiconductor package.

In accordance with another aspect of the present invention, there is provided a semiconductor packaging method including preparing a plurality of divided chips from at least one substrate structure by a dicing process, bonding the plurality of chips to a target surface of a carrier substrate using a chip bonding apparatus, the chip bonding apparatus including a bonding head, the bonding head including a plurality of chip holding units, each of which is configured to individually hold a chip, the bonding head being configured to adjust the interval between the plurality of chip holding units, bonding the chips to the target surface at controlled intervals using the plurality of chip holding units according to a multi-chip bonding method, forming a molding layer configured to cover the plurality of chips on the carrier substrate, removing the carrier substrate from the plurality of chips and the molding layer, and dividing a package structure comprising the plurality of chips and the molding layer into package device units.

The plurality of chip holding units may include a first group of chip holding units arranged in line in a first direction, and the bonding head may be configured to move at least one of the first group of chip holding units in a direction parallel to the first direction.

The plurality of chip holding units may be arranged to form a plurality of rows in a first direction and a plurality of columns in a second direction perpendicular to the first direction, and the bonding head may be configured to move at least one of the plurality of chip holding units in a direction parallel to the first direction and to move at least one of the plurality of chip holding units in a direction parallel to the second direction.

The bonding head may include at least one linear motor, and the chip bonding apparatus may be configured to adjust the interval between the plurality of chip holding units using the at least one linear motor.

The bonding head may include a rod type member extending in a first direction and a first group of chip holding units coupled to the rod type member, at least one of the first group of chip holding units being configured to be linearly movable in a direction parallel to the first direction.

The bonding head may include first and second rod type members extending side by side in a first direction and spaced apart from each other in a second direction perpendicular to the first direction, the interval between the first and second rod type members being adjusted in the second direction, a first group of chip holding units coupled to the first rod type member, at least one of the first group of chip holding units being configured to be linearly movable along the first rod type member in a direction parallel to the first direction, and a second group of chip holding units coupled to the second rod type member, at least one of the second group of chip holding units being configured to be linearly movable along the second rod type member in a direction parallel to the first direction.

The semiconductor packaging method may be applied to a flip chip type semiconductor package in a fan-out wafer level package (FOWLP) or fan-out panel level package (FOPLP).

The semiconductor packaging method may include picking up a first group of chips, among the plurality of chips, using a pickup device including a pickup head, flipping the pickup head upside down to reverse upward and downward directions of the first group of chips, and transferring at least two of the first group of chips having the upward and downward directions reversed to the carrier substrate using the chip bonding apparatus.

The semiconductor packaging method may include adjusting the interval between the at least two chips by adjusting the interval between the plurality of chip holding units in the state in which the at least two chips are held by the plurality of chip holding units, respectively and bonding the at least two chips with the adjusted interval to the target surface.

The semiconductor packaging method may include picking up a first group of chips, among the plurality of chips, and disposing the first group of chips on a shuttle member using a pickup device, flipping the shuttle member upside down such that upward and downward directions of the first group of chips are reversed and disposing the shuttle member on an intermediate transfer plate, and transferring the first group of chips having the upward and downward directions reversed to the carrier substrate using the chip bonding apparatus.

### BRIEF DESCRIPTION OF THE DRAWINGS

FIG. 1 is a view illustrating a chip bonding apparatus for semiconductor packaging according to an embodiment of the present invention;
FIG. 2 is a view showing the case in which the interval between a plurality of chip holding units is adjusted to adjust the interval between a plurality of chips held thereby in FIG. 1;
FIG. 3 is a plan view illustrating a chip bonding apparatus for semiconductor packaging according to another embodiment of the present invention;
FIG. 4 is a plan view showing the case in which the interval between a plurality of chip holding units is adjusted in FIG. 3;
FIG. 5 is a plan view illustrating a chip bonding apparatus for semiconductor packaging according to another embodiment of the present invention;
FIG. 6 is a plan view showing the case in which the interval between a plurality of chip holding units is adjusted in FIG. 5;
FIG. 7 is a plan view illustrating a chip bonding apparatus for semiconductor packaging according to another embodiment of the present invention;
FIG. 8 is a plan view showing the case in which the interval between a plurality of chip holding units is adjusted in FIG. 7;
FIG. 9 is a plan view illustrating a chip bonding apparatus for semiconductor packaging according to another embodiment of the present invention;
FIG. 10 is a plan view showing the case in which the interval between a plurality of chip holding units is adjusted in FIG. 9;
FIG. 11 is a plan view illustrating a chip bonding apparatus for semiconductor packaging according to a further embodiment of the present invention;
FIG. 12 is a plan view showing the case in which the interval between a plurality of chip holding units is adjusted in FIG. 11;
FIGs. 13A to 13H are views illustrating a semiconductor packaging method according to an embodiment of the present invention; and
FIGs. 14A to 14D are sectional views illustrating a semiconductor packaging method according to another embodiment of the present invention.

### DETAILED DESCRIPTION OF THE PREFERRED EMBODIMENTS

Hereinafter, embodiments of the present invention will be described in detail with reference to the accompanying drawings.

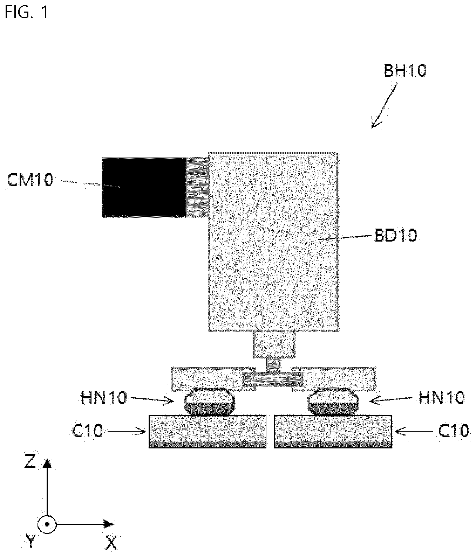

FIG. 1 is a view illustrating a chip bonding apparatus for semiconductor packaging according to an embodiment of the present invention.

Referring to FIG. 1, the chip bonding apparatus according to the embodiment of the present invention may include a bonding head BH10. The bonding head BH10 may include a plurality of chip holding units HN10, each of which individually holds a chip C10 (i.e., a die). Each of the plurality of chip holding units HN10 is capable of picking up one chip C10, disposing the same on a given target surface, and bonding the same, and may be referred to as a kind of bonding collet or bond collet. Accordingly, the plurality of chip holding units HN10 may be referred to as a plurality of bonding collets. The bonding head BH10 may be configured to adjust the interval between the plurality of chip holding units HN10. By adjusting the interval between the plurality of chip holding units HN10, the bonding head BH10 may adjust the interval between the plurality of chips C10 held thereby. The chip bonding apparatus may be configured to bond the plurality of chips C10 to a given target surface at controlled intervals using the plurality of chip holding units HN10 according to a multi-chip bonding method.

The bonding head BH10 may include a head body BD10. The head body BD10 may include mechanical elements and/or electrical control elements. The plurality of chip holding units HN10 may be installed on an end (e.g., lower end) of the head body BD10 by connection or coupling. The plurality of chip holding units HN10 may be a tool present at a distal end of the bonding head BH10. The chip holding unit HN10 may suction and hold the chip C10, for example, using a vacuum suction method, and may release the vacuum suction to place the chip C10 on the predetermined target surface. In addition, the chip holding unit HN10 may press the chip C10 against the target surface at a predetermined pressure. Furthermore, the chip holding unit HN10 may include a cushioning member, and damage to a surface portion of the chip C10 may be prevented by the cushioning member. The bonding head BH10 may be configured to be movable in X-axis, Y-axis, and Z-axis directions. In some cases, the bonding head BH10 may be configured to be rotatable.

The bonding head BH10 may further include a camera member CM10 coupled or connected to the head body BD10. As a non-limiting example, the camera member CM10 may be installed on one side of the head body BD10. The camera member CM10 may be a down-looking type image acquisition device. The camera member CM10 may be used, for example, in a packaging process, to photograph and detect an alignment key present on a carrier substrate to determine where to dispose the plurality of chips C10.

The chip bonding apparatus may be applied to bond the plurality of chips C10 to the predetermined target surface according to a multi-chip bonding method, wherein a flip chip bonding method may be applied to bond the chips C10. In other words, the chip C10 may be bonded to the target surface in the state in which an active surface portion on which a circuit is formed faces downward. The flip chip bonding method may be advantageous for semiconductor packages in terms of direct connection, shortened connection path, and the like.

According to an embodiment, the plurality of chip holding units HN10 may include a first group of chip holding units arranged in line in a first direction, and the bonding head BH10 may be configured to move at least one of the first group of chip holding units in a direction parallel to the first direction. Accordingly, the interval between the first group of chip holding units in the first direction may be adjusted.

According to another embodiment, the plurality of chip holding units HN10 may be arranged to form a plurality of rows in a first direction and a plurality of columns in a second direction perpendicular to the first direction, and the bonding head BH10 may be configured to move at least one of the plurality of chip holding units HN10 in a direction parallel to the first direction and to move at least one of the plurality of chip holding units HN10 in a direction parallel to the second direction. Accordingly, the interval between the plurality of chip holding units HN10 in the first direction and the interval between the plurality of chip holding units HN10 in the second direction may be adjusted.

As a more specific embodiment, the bonding head BH10 may include at least one linear motor and may be configured to adjust the interval between the plurality of chip holding units HN10 using the at least one linear motor. In this case, the bonding head BH10 may adjust the interval between the plurality of chip holding units HN10 using at least one motorized linear slide member. The interval between the plurality of chip holding units HN10 may be precisely and accurately adjusted by precisely driving the linear motor.

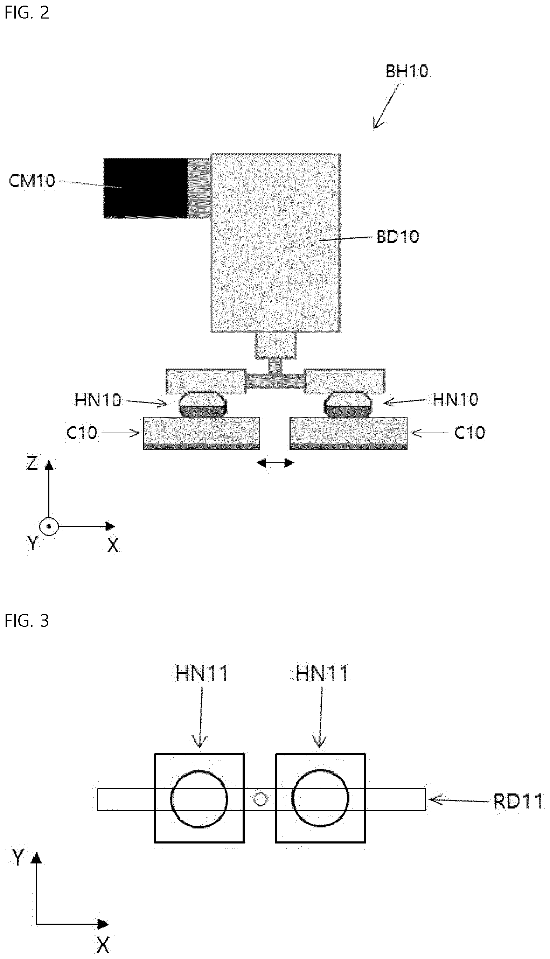

FIG. 2 is a view showing the case in which the interval between the plurality of chip holding units HN10 is adjusted to adjust the interval between the plurality of chips C10 held thereby in FIG. 1.

FIG. 3 is a plan view illustrating a chip bonding apparatus for semiconductor packaging according to another embodiment of the present invention.

Referring to FIG. 3, the chip bonding apparatus according to the present embodiment may include a bonding head, wherein the bonding head may include a rod type member RD11 extending in a first direction (e.g., X-axis direction) and a first group of chip holding units HN11 coupled to the rod type member RD11. At least one of the first group of chip holding units HN11 may be configured to be linearly movable in a direction parallel to the first direction.

The rod type member RD11 may be or include a stator of a linear motor. One or more movers of the linear motor may be installed on the rod type member RD11. At least one of the first group of chip holding units HN11 may be coupled to the mover and moved therewith. For example, two chip holding units HN11 may be coupled to different movers. The two chip holding units HN11 may be moved in a direction away from each other and may also be moved in a direction closer to each other.

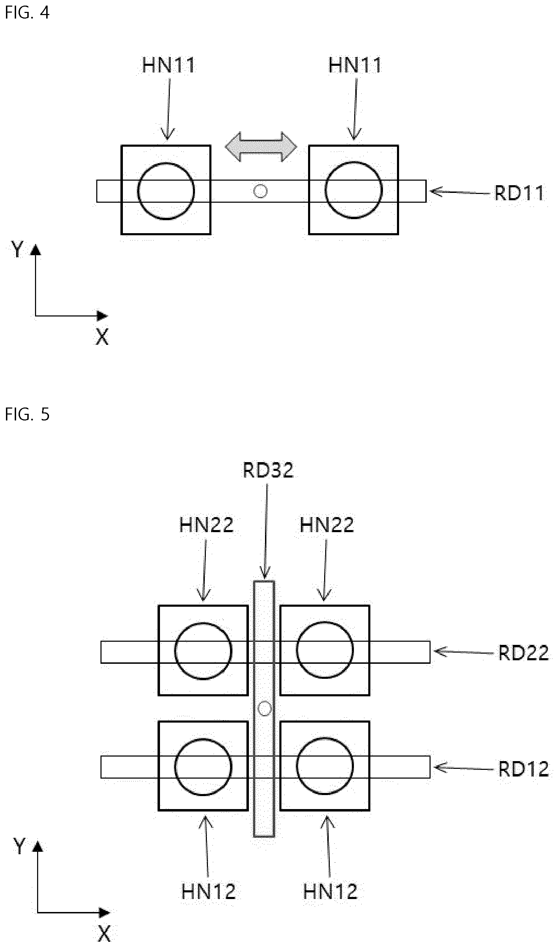

FIG. 4 is a plan view showing the case in which the interval between the plurality of chip holding units HN11 is adjusted in FIG. 3.

FIG. 5 is a plan view illustrating a chip bonding apparatus for semiconductor packaging according to another embodiment of the present invention.

Referring to FIG. 5, the chip bonding apparatus according to the present embodiment may include a bonding head, wherein the bonding head may include first and second rod type members RD12 and RD22 extending side by side in a first direction (e.g., X-axis direction) and spaced apart from each other in a second direction (e.g., Y-axis direction) perpendicular to the first direction, the interval between the first and second rod type members being adjusted in the second direction. The bonding head may include a first group of chip holding units HN12 coupled to the first rod type member RD12. At least one of the first group of chip holding units HN12 may be configured to be linearly movable along the first rod type member RD12 in a direction parallel to the first direction. In addition, the bonding head may include a second group of chip holding units HN22 coupled to the second rod type member RD22. At least one of the second group of chip holding units HN22 may be configured to be linearly movable along the second rod type member RD22 in a direction parallel to the first direction.

The first rod type member RD12 may correspond to a stator of a first linear motor. One or more movers of the first linear motor may be installed on the first rod type member RD12. At least one of the first group of chip holding units HN12 may be coupled to the mover of the first linear motor and may be moved therewith. For example, two chip holding units HN12 may be coupled to different movers. Similarly, the second rod type member RD22 may correspond to a stator of a second linear motor. One or more movers of the second linear motor may be installed on the second rod type member RD22. At least one of the second group of chip holding units HN22 may be coupled to the mover of the second linear motor and may be moved therewith. For example, two chip holding units HN22 may be coupled to different movers.

In addition, the bonding head may further include a third rod type member RD32 extending in the second direction (e.g., Y-axis direction). The third rod type member RD32 may be disposed, for example, on (above) the first and second rod type members RD12 and RD22. The third rod type member RD32 may be structurally connected/coupled to the first and second rod type members RD12 and RD22. As an example, the third rod type member RD32 may be structurally connected/coupled to a middle portion of each of the first and second rod type members RD12 and RD22 or a part adjacent thereto. The third rod type member RD32 may correspond to a stator of a third linear motor. One or more movers of the third linear motor may be installed on the third rod type member RD32. At least one of the first and second rod type members RD12 and RD22 may be coupled to the mover of the third linear motor and may be moved therewith. For example, the first and second rod type members RD12 and RD22 may be coupled to different movers.

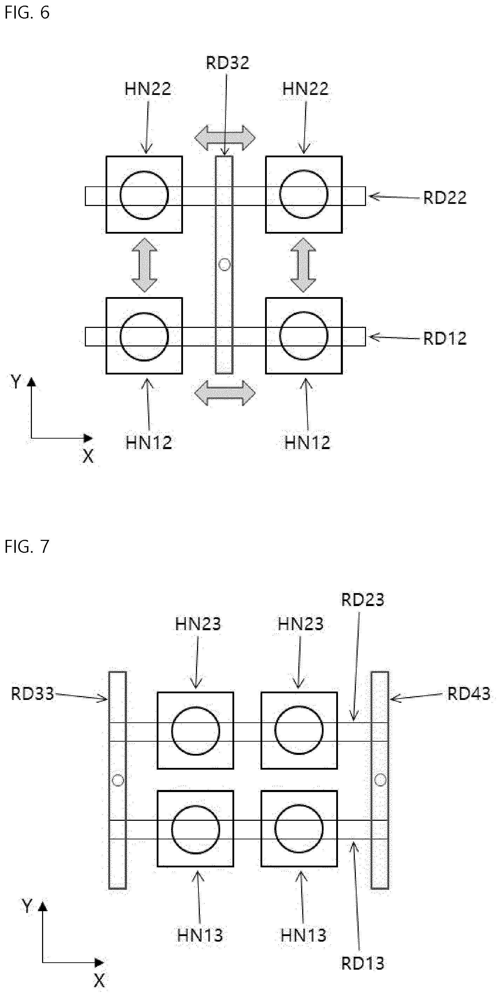

FIG. 6 is a plan view showing the case in which the interval between the plurality of chip holding units HN12 and HN22 is adjusted in FIG. 5.

FIG. 7 is a plan view illustrating a chip bonding apparatus for semiconductor packaging according to another embodiment of the present invention.

Referring to FIG. 7, the chip bonding apparatus according to the present embodiment may include a bonding head, wherein the bonding head may include first and second rod type members RD13 and RD23 extending side by side in a first direction (e.g., X-axis direction) and spaced apart from each other in a second direction (e.g., Y-axis direction) perpendicular to the first direction, the interval between the first and second rod type members being adjusted in the second direction. The bonding head may include a first group of chip holding units HN13 coupled to the first rod type member RD13. At least one of the first group of chip holding units HN13 may be configured to be linearly movable along the first rod type member RD13 in a direction parallel to the first direction. In addition, the bonding head may include a second group of chip holding units HN23 coupled to the second rod type member RD23. At least one of the second group of chip holding units HN23 may be configured to be linearly movable along the second rod type member RD23 in a direction parallel to the first direction.

The configuration and connection relationship of the first rod type member RD13 and the first group of chip holding units HN13 may be identical or similar to those of the first rod type member RD12 and the first group of chip holding units HN12 described with reference to FIG. 5. Similarly, the configuration and connection relationship of the second rod type member RD23 and the second group of chip holding units HN23 may be identical or similar to those of the second rod type member RD22 and the second group of chip holding units HN22 described with reference to FIG. 5.

The bonding head may further include third and fourth rod type members RD33 and RD43 extending in the second direction (e.g., Y-axis direction) and spaced apart from each other in the first direction (e.g., X-axis direction). The third and fourth rod type members RD33 and RD43 may be disposed, for example, on (above) the first and second rod type members RD13 and RD23. Each of the third and fourth rod type members RD33 and RD43 may be structurally connected/coupled to the first and second rod type members RD13 and RD23. For example, the third rod type member RD33 may be structurally connected/coupled to one end of each of the first and second rod type members RD13 and RD23 or a part adjacent thereto. The fourth rod type member RD43 may be structurally connected/coupled to the other end of each of the first and second rod type members RD13 and RD23 or a part adjacent thereto.

The third rod type member RD33 may correspond to a stator of a third linear motor. One or more movers of the third linear motor may be installed on the third rod type member RD33. At least one of the first and second rod type members RD13 and RD23 may be coupled to the mover of the third linear motor and may be moved therewith. For example, the first and second rod type members RD13 and RD23 may be coupled to different movers of the third linear motor. The fourth rod type member RD43 may correspond to a stator of a fourth linear motor. One or more movers of the fourth linear motor may be installed on the fourth rod type member RD43. At least one of the first and second rod type members RD13 and RD23 may be coupled to the mover of the third linear motor and may be moved therewith. For example, the first and second rod type members RD13 and RD23 may be coupled to different movers of the fourth linear motor. In some cases, any one of the third and fourth rod type members RD33 and RD43 may be a movement guide member that does not have the configuration of a linear motor.

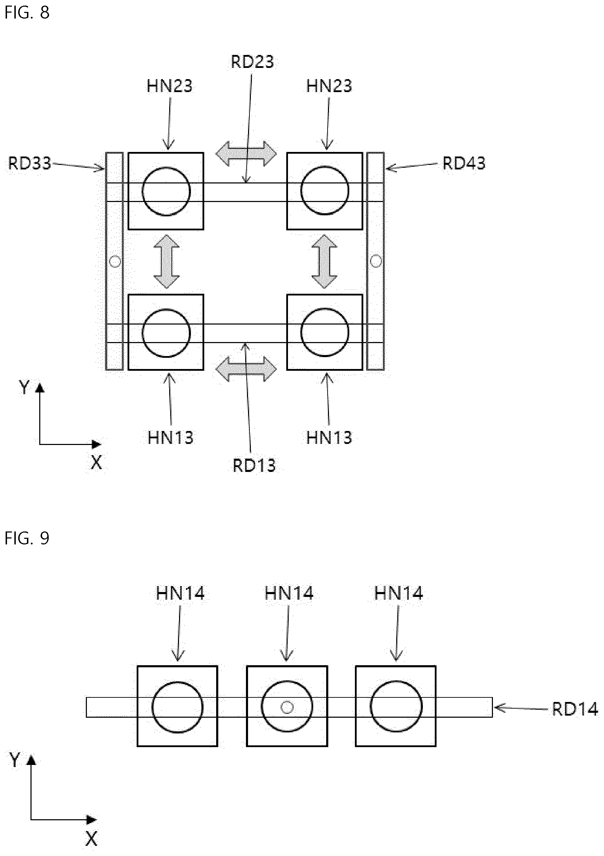

FIG. 8 is a plan view showing the case in which the interval between the plurality of chip holding units HN13 and HN23 is adjusted in FIG. 7.

In the embodiments of FIGs. 3 to 8, the number of the plurality of chip holding units may be further increased. In addition, the number of the rod type members extending in the first direction and/or the number of the rod type members extending in the second direction may also be increased.

FIG. 9 is a plan view illustrating a chip bonding apparatus for semiconductor packaging according to another embodiment of the present invention.

Referring to FIG. 9, the chip bonding apparatus according to the present embodiment may include a bonding head, wherein the bonding head may include a rod type member RD14 extending in a first direction (e.g., X-axis direction) and a first group of chip holding units HN14 coupled to the rod type member RD14. At least one of the first group of chip holding units HN14 may be configured to be linearly movable in a direction parallel to the first direction.

The rod type member RD14 may be or include a stator of a linear motor. One or more movers of the linear motor may be installed on the rod type member RD14. At least one of the first group of chip holding units HN14 may be coupled to the mover and may be moved therewith. For example, a middle one of three chip holding units HN14 may not be coupled to a mover and may not be moved, and the chip holding units HN14 on both sides may be coupled to different movers and may be moved therewith. If the number of the plurality of chip holding units HN14 is an odd number, the middle chip holding unit HN14 may not be coupled to a mover and may not be moved.

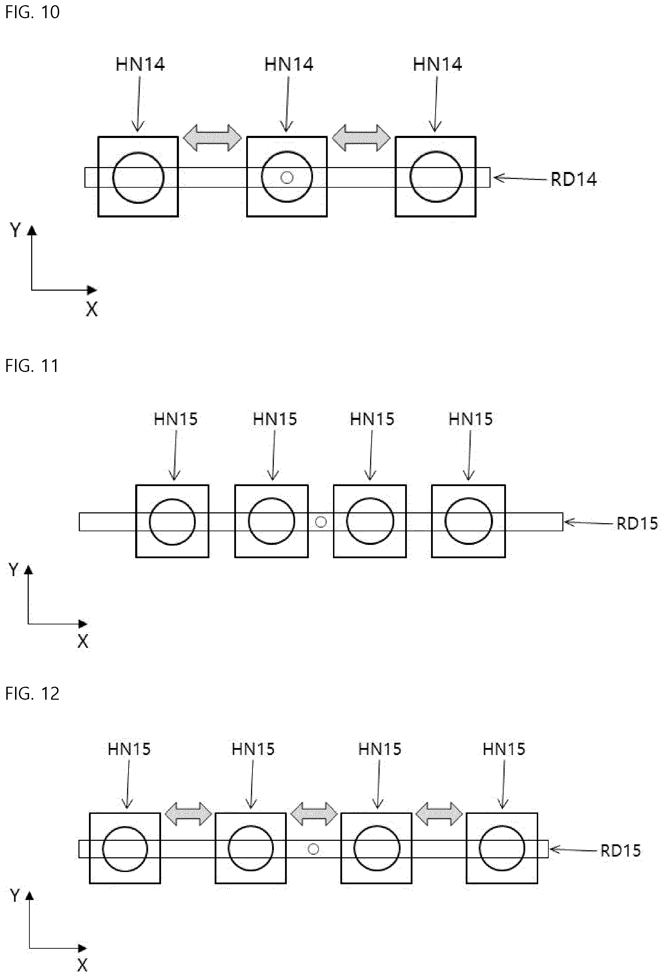

FIG. 10 is a plan view showing the case in which the interval between the plurality of chip holding units HN14 is adjusted in FIG. 9.

FIG. 11 is a plan view illustrating a chip bonding apparatus for semiconductor packaging according to a further embodiment of the present invention.

Referring to FIG. 11, the chip bonding apparatus according to the present embodiment may include a bonding head, wherein the bonding head may include a rod type member RD15 extending in a first direction (e.g., X-axis direction) and a first group of chip holding units HN15 coupled to the rod type member RD15. At least one of the first group of chip holding units HN15 may be configured to be linearly movable in a direction parallel to the first direction.

The rod type member RD15 may be or include a stator of a linear motor. One or more movers of the linear motor may be installed on the rod type member RD15. At least one of the first group of chip holding units HN15 may be coupled to the mover and may be moved therewith. For example, four chip holding units HN15 may be coupled to different movers and may be moved therewith. If the number of the plurality of chip holding units HN15 is an even number, all of the chip holding units may be coupled to respective movers and may be moved therewith. However, in some cases, a chip holding unit present at one end may not be coupled to a mover, and the other chip holding units may be coupled to respective movers.

FIG. 12 is a plan view showing the case in which the interval between the plurality of chip holding units HN15 is adjusted in FIG. 11.

The chip bonding apparatus according to the embodiment of the present invention may be applied to a fan-out wafer level package (FOWLP) or fan-out panel level package (FOPLP) type semiconductor package. In particular, the chip bonding apparatus may be usefully applied to flip chip type chip bonding in the FOWLP or FOPLP type semiconductor package. A single bonding head BH10 or a plurality of bonding heads BH10 may be used in a semiconductor package process. If the plurality of bonding heads BH10 is used, the number may be two or more. The chip bonding apparatus may attach chips C10 to a target surface of a carrier substrate according to a multi-chip bonding method of simultaneously bonding multiple chips C10 at once, and may precisely and accurately control the interval between the chips C10 depending on the package design and the package size and may bond the chips to the target surface. When the chip bonding apparatus is used, therefore, it is possible to greatly improve process efficiency while securing precision in semiconductor packaging. Particularly, in fan-out type and flip chip type semiconductor packages, it is possible to greatly shorten the process time and to reduce the burden on equipment input and operation.

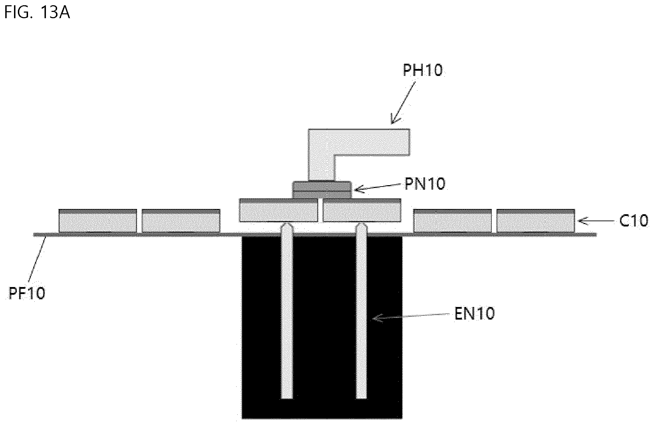

FIGs. 13A to 13H are views illustrating a semiconductor packaging method according to an embodiment of the present invention.

Referring to FIG. 13A, a plurality of divided chips C10 (i.e., dies) may be prepared from at least one substrate structure (wafer structure) through a dicing process. The chips C10 may be semiconductor chips. In an actual process, the number of chips C10 may be greater than that shown in FIG. 13A. The plurality of chips C10 may be disposed on a predetermined polymer film PF10, for example, in the form of a wafer as a whole. The polymer film PF10 may be, for example, but not limited to, a mylar film.

Two or more chips C10 may be simultaneously picked up using a pickup head PH10 of a pickup device. The pickup head PH10 may also be referred to as a pickup arm. The two or more chips C10 that are picked up may be referred to as a first group of chips. A chip pickup unit PN10 may be disposed at an end of the pickup head PH10, and the two or more chips C10 may be simultaneously picked up using the chip pickup unit PN10. The chip pickup unit PN10 may be referred to as a pickup collet or a pick collet. The chip pickup unit PN10 may pick up, for example, two, four, or nine or more chips C10 in a reticle. However, the number of chips C10 that are picked up by the chip pickup unit PN10 at once is not limited thereto. The size and shape of the chip pickup unit PN10 may be variously changed. The chip pickup unit PN10 may pick up the chips C10 by suctioning the same, for example, using a vacuum suction method. In addition, the chip pickup unit PN10 may release the chip C10 by releasing vacuum suction. The pickup head PH10 may be configured to be movable in the X-axis, Y-axis, and Z-axis directions, and furthermore, may be configured to be rotatable.

As an example, an ejector needle member EN10 may lift chips C10 to be picked up, i.e., the first group of chips C10, under the polymer film PF10, and the pickup head PH10 may pick up the chips C10.

Although not shown, a down-looking camera (wafer camera) device may be used to confirm the position of the chips C10 to be picked up and to perform the chip pickup operation as described above with precision and accuracy.

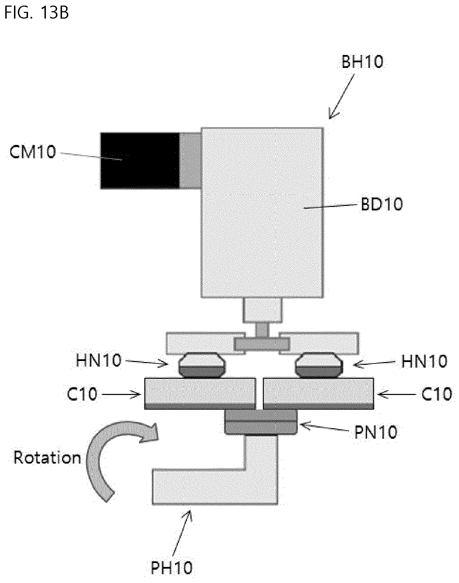

Referring to FIG. 13B, the upward and downward directions of the first group of chips C10 may be reversed by flipping the pickup head PH10 upside down. To this end, the pickup head PH10 may be rotated by 180°. Thus, active surface portions of the first group of chips C10 may face downward. In this state, at least two of the first group of chips C10 may be delivered from the pickup head PH10 to the bonding head BH10 of the chip bonding apparatus. Above the pickup head PH10, the bonding head BH10 may hold and pick up at least two of the first group of chips C10. The chips C10 may be individually held by a plurality of chip holding units HN10 of the bonding head BH10, respectively. Here, the configuration of the chip bonding apparatus including the bonding head BH10 may be identical to what has been previously described with reference to FIGs. 1 to 12. The chip bonding apparatus may include a bonding head BH10, wherein the bonding head BH10 may include a plurality of chip holding units HN10, each of which individually holds a chip C10, and the interval between the plurality of chip holding units HN10 may be adjusted. All of what has been described with reference to FIGs. 1 to 12 may be applied to the chip bonding apparatus.

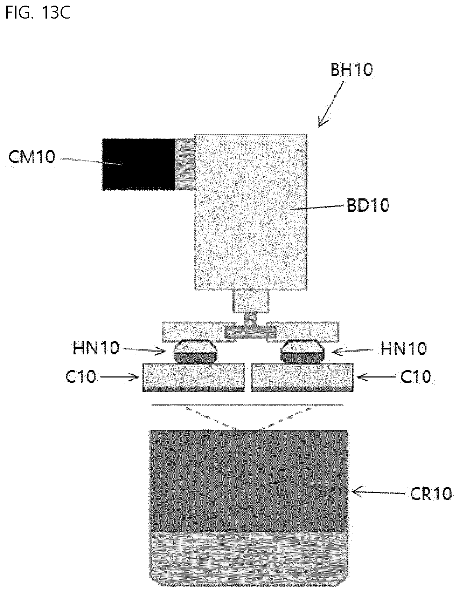

Referring to FIG. 13C, a camera device CR10 may be used to recognize (check) the pattern, interval, etc. of the plurality of chips C10 held (picked up) by the plurality of chip holding units HN10. The camera device CR10 may be an up-looking type camera device. The chip offsets, i.e., the die offsets, may be checked by moving the bonding head BH10 to the camera device CR10. Since the position of the chips may slightly vary due to heat or the like in the transfer of the chips (dies), the camera device CR10 may be used to check the position and movement of the chips.

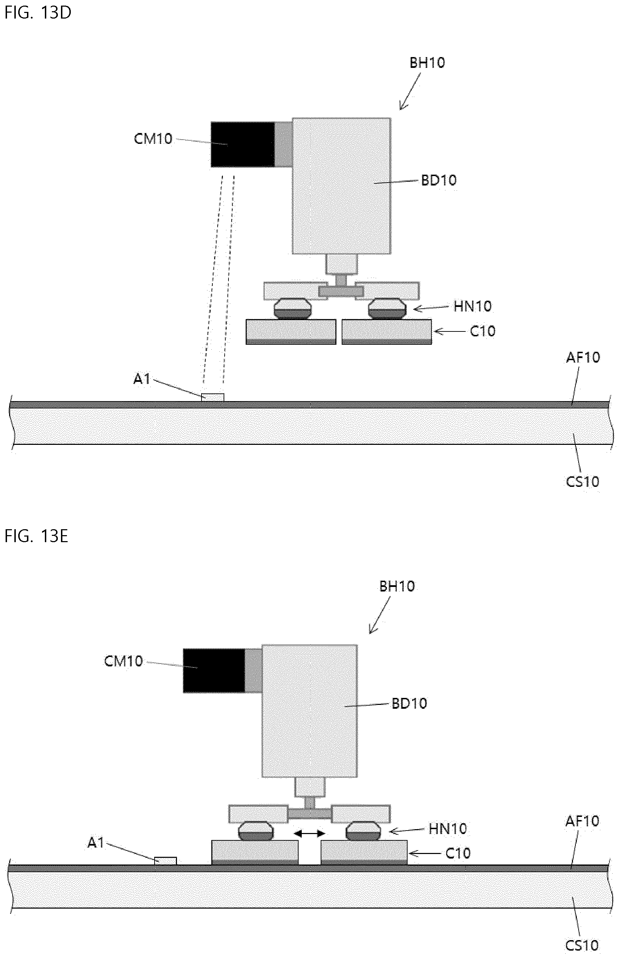

Referring to FIG. 13D, the bonding head BH10 may be moved above a carrier substrate CS10, and the bonding position may be checked using a camera member CM10 installed on the bonding head BH10. The position for bonding the plurality of chips C10 may be checked by photographing and detecting an alignment key A1 present on the carrier substrate CS10 using the camera member CM10. A predetermined adhesive film AF10 may be attached to the carrier substrate CS10, and the alignment key A1 may be disposed on the adhesive film AF10. The adhesive film AF10 may be a kind of adhesive tape. The adhesive film AF10 may be considered to be included in the carrier substrate CS10. The alignment key A1 may be an alignment reference element (a kind of pattern or die).

The carrier substrate CS10 may be a circular wafer or a quadrangular panel. If the carrier substrate CS10 is a wafer, the packaging method according to the present embodiment may correspond to a fan-out wafer level package (FOWLP). If the carrier substrate CS10 is a quadrangular panel, the packaging method according to the present embodiment may correspond to a fan-out panel level package (FOPLP). In addition, the packaging method according to the present embodiment may be a chip-first process.

Referring to FIG. 13E, the plurality of chips C10 may be bonded to a target surface of the carrier substrate CS10 using the chip bonding apparatus, wherein the plurality of chip holding units HN10 may be used to bond the chips C10 to the target surface at controlled intervals according to a multi-chip bonding method. In the state in which at least two chips C10 are held by the plurality of chip holding units HN10, respectively, the interval between the at least two chips C10 may be adjusted by adjusting the interval between the plurality of chip holding units HN10, and the at least two chips C10 with the adjusted interval may be bonded to the target surface. The at least two chips C10 may be bonded to the adhesive film AF10. In the present embodiment, the at least two chips C10 of the first group of chips flipped upside down may be transferred to the carrier substrate CS10 and bonded thereto. That is, the at least two chips C10 may be bonded to the carrier substrate CS10 while facing downward using a flip chip bonding method.

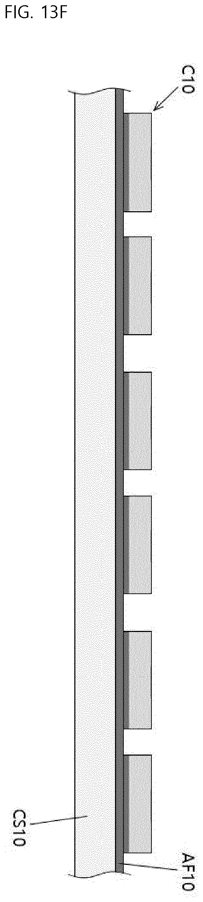

Referring to FIG. 13F, the process of bonding the plurality of chips C10 on the carrier substrate CS10 at given intervals may be completed. Here, the plurality of chips C10 may be the same type of chip, but may also include different types of heterogeneous chips. In addition, the interval between the plurality of chips C10 may be one identical interval or may include two or more different intervals. Depending on the package design and the package size, the interval(s) between the plurality of chips C10 may be determined.

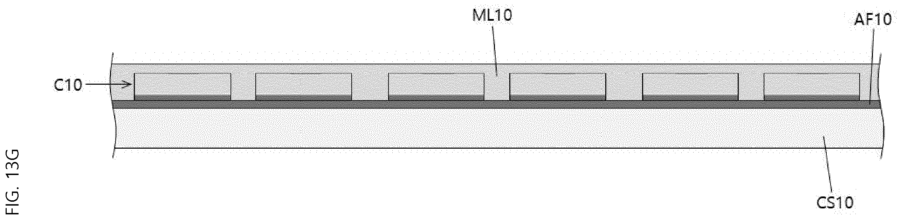

Referring to FIG. 13G, a molding layer ML10 configured to cover the plurality of chips C10 may be formed on the carrier substrate CS10. The molding layer ML10 may include a polymer material. For example, the molding layer ML10 may include a molding compound.

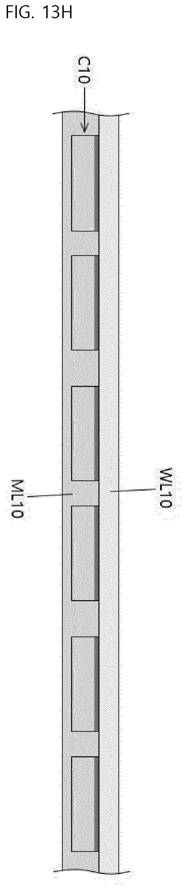

Referring to FIG. 13H, the carrier substrate CS10 (FIG. 13G) may be removed from the plurality of chips C10 and the molding layer ML10. At this time, the adhesive film AF10 (FIG. 13G) may also be removed. Subsequently, a wiring layer WL10 may be formed on the plurality of chips C10 and the molding layer ML10. The wiring layer WL10 may be formed to be in contact with an active surface portion of each of the plurality of chips C10. In addition, although not shown, a plurality of electrical connection elements may be further formed on the wiring layer WL10. As a non-limiting example, the plurality of electrical connection elements may include solder balls or bumps. The plurality of chips C10, the molding layer ML10, and the wiring layer WL10 may be said to constitute a package structure.

Subsequently, although not shown, the package structure may be divided (cut) into packaged device units. This may be performed according to a conventional dividing (cutting) method. As a result, individualized semiconductor package elements may be obtained.

The semiconductor packaging method according to the embodiment of the present invention may be applied to a FOWLP or FOPLP type semiconductor package. In particular, the semiconductor packaging method may be usefully applied to a flip chip type semiconductor package in the FOWLP or FOPLP. In the semiconductor packaging method, it is possible to attach chips C10 to a target surface of a carrier substrate CS10 according to a multi-chip bonding method of simultaneously bonding multiple chips C10 at once, and it is possible to precisely and accurately control the interval between the chips C10 depending on the package design and the package size and to bond the chips to the target surface. When the semiconductor packaging method according to the embodiment is used, therefore, it is possible to greatly improve process efficiency while securing precision in semiconductor packaging. Particularly, in fan-out type and flip chip type semiconductor packages, it is possible to greatly shorten the process time and to reduce the burden on equipment input and operation.

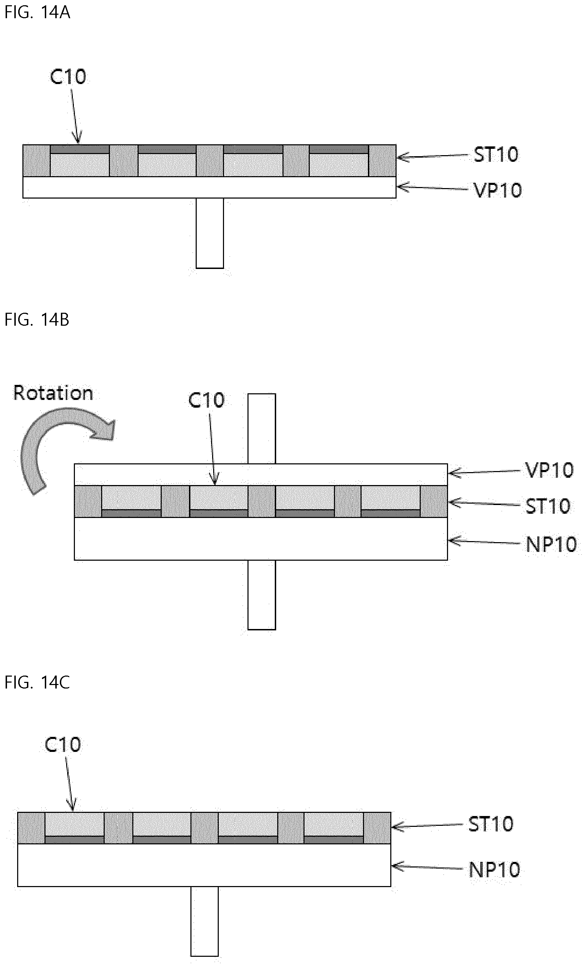

FIGs. 14A to 14D are sectional views illustrating a semiconductor packaging method according to another embodiment of the present invention.

Referring to FIG. 14A, a plurality of divided chips C10 (i.e., dies) may be prepared from at least one substrate structure (wafer structure) through a dicing process. Among the plurality of chips, a first group of chips C10 may be picked up using a pickup device and disposed on a shuttle member ST10. For example, the pickup device may pick up the chips C10 one by one and dispose the same on the shuttle member ST10.

The shuttle member ST10 may have a grid type structure capable of limiting the interval between the chips. The shuttle member ST10 may have a plurality of chip insertion spaces, and a chip C10 may be disposed in each of the plurality of chip insertion spaces. The shuttle member ST10 may be manufactured in a variety of ways to suit the package design. In addition, the shuttle member ST10 may be disposed on a predetermined vacuum plate VP10. The vacuum plate VP10 may serve to hold the shuttle member ST10 and the chips C10 by vacuum suctioning. The size and shape of the shuttle member ST10 and the number of chips C10 shown herein are exemplary and may be changed.

Referring to FIG. 14B, the shuttle member ST10 may be flipped upside down such that the upward and downward directions of the first group of chips C10 are reversed, and may be disposed on an intermediate transfer plate NP10. In the state in which the shuttle member ST10 and the chips C10 are suctioned to the vacuum plate VP10 by vacuum, the vacuum plate VP10 may be rotated 180°, and the shuttle member ST10 and the chips C10 may be disposed on the intermediate transfer plate NP10. Thus, active surface portions of the first group of chips C10 may face downward.

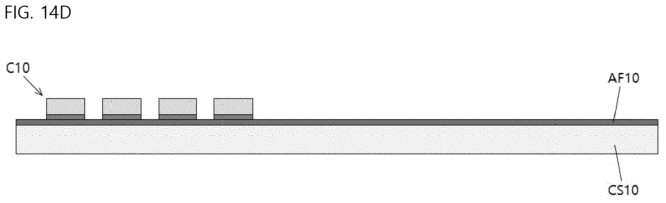

Referring to FIG. 14C, the vacuum plate VP10 (FIG. 14B) may be removed from the shuttle member ST10. Subsequently, the first group of chips C10 having the upward and downward directions reversed may be transferred to a carrier substrate and bonded to a target surface using the chip bonding apparatus according to the embodiment of the present invention. The resulting product may be as shown in FIG. 14D.

Referring to FIG. 14D, an adhesive film AF10 may be attached to the carrier substrate CS10, and the first group of chips C10 may be bonded to the carrier substrate CS10 via the adhesive film AF10. The first group of chips C10 may be bonded to the carrier substrate CS10 according to a multi-chip bonding method using the chip bonding apparatus according to the embodiment of the present invention.

Although not shown, after bonding all required chips on the carrier substrate CS10, the semiconductor packaging process may be completed according to the method described with reference to FIGs. 13G and 13H.

In the present embodiment, since the interval between the chips can be preset by the shuttle member ST10, the bonding head of the chip bonding apparatus may bond the first group of chips C10 to the carrier substrate CS10 while maintaining the interval between the chips set by the shuttle member ST10. The plurality of chip holding units of the bonding head may perform the multi-chip bonding process in the state in which the interval between the chips is controlled according to the interval between the chips set by the shuttle member ST10.

However, in some cases, the semiconductor packaging method described with reference to FIGs. 14A to 14D may be variously changed. For example, in transferring and bonding the first group of chips C10 to the carrier substrate CS10, the configuration of the chip bonding apparatus according to the embodiment of the present invention may not be used. As an example, a chip bonding apparatus including a bonding head having a predetermined vacuum plate may be used, and the first group of chips C10 may be transferred and bonded to the carrier substrate CS10 using the vacuum plate. Various other variations may be possible.

As is apparent from the above description, according to embodiments of the present invention, it is possible to implement a chip bonding apparatus capable of bonding a plurality of chips to a given target surface at controlled intervals according to a multi-chip bonding method, thereby significantly improving process efficiency while securing precision in semiconductor packaging. In addition, according to the embodiments of the present invention, it is possible to implement a semiconductor packaging method capable of securing high efficiency and accuracy by applying the chip bonding apparatus.

When the chip bonding apparatus and the semiconductor packaging method according to the embodiments of the present invention are used, it is possible to significantly shorten the process time and reduce the burden on equipment input and operation in a fan-out type semiconductor package. In particular, the chip bonding apparatus and the semiconductor packaging method according to the embodiments may be quite usefully applied to a flip chip type package in a fan-out wafer level package (FOWLP) or a fan-out panel level package (FOPLP) .

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the chip bonding apparatus for semiconductor packaging and the semiconductor packaging method according to the embodiments described with reference to FIGs. 1 to 14D may be subject to various substitutions, changes, and modifications without departing from the technical ideas of the present invention. As a specific example, it will be appreciated that the apparatus and the method according to the embodiments of the present invention may also be applied to a chip-last (i.e., die-last) package process and the like. The scope of the invention is therefore not to be defined by the embodiments described above but by the technical ideas recited in the appended claims.

## Claims

1. A chip bonding apparatus for semiconductor packaging, the chip bonding apparatus comprising:
a bonding head, wherein
the bonding head comprises a plurality of chip holding units, each of which is configured to individually hold a chip, the bonding head being configured to adjust an interval between the plurality of chip holding units, and
the chip bonding apparatus is configured to bond a plurality of chips to a given target surface at controlled intervals using the plurality of chip holding units according to a multi-chip bonding method.

2. The chip bonding apparatus according to claim 1, wherein
the plurality of chip holding units comprises a first group of chip holding units arranged in line in a first direction, and
the bonding head is configured to move at least one of the first group of chip holding units in a direction parallel to the first direction.

3. The chip bonding apparatus according to claim 1, wherein
the plurality of chip holding units is arranged to form a plurality of rows in a first direction and a plurality of columns in a second direction perpendicular to the first direction, and
the bonding head is configured to move at least one of the plurality of chip holding units in a direction parallel to the first direction and to move at least one of the plurality of chip holding units in a direction parallel to the second direction.

4. The chip bonding apparatus according to claim 1, wherein the bonding head comprises at least one linear motor and is configured to adjust the interval between the plurality of chip holding units using the at least one linear motor.

5. The chip bonding apparatus according to claim 1, wherein the bonding head comprises:
a rod type member extending in a first direction; and
a first group of chip holding units coupled to the rod type member, at least one of the first group of chip holding units being configured to be linearly movable in a direction parallel to the first direction.

6. The chip bonding apparatus according to claim 1, wherein the bonding head comprises:
first and second rod type members extending side by side in a first direction and spaced apart from each other in a second direction perpendicular to the first direction, an interval between the first and second rod type members being adjusted in the second direction;
a first group of chip holding units coupled to the first rod type member, at least one of the first group of chip holding units being configured to be linearly movable along the first rod type member in a direction parallel to the first direction; and
a second group of chip holding units coupled to the second rod type member, at least one of the second group of chip holding units being configured to be linearly movable along the second rod type member in a direction parallel to the first direction.

7. The chip bonding apparatus according to claim 1, wherein the chip bonding apparatus is applied to flip chip type chip bonding in a fan-out wafer level package (FOWLP) or fan-out panel level package (FOPLP) type semiconductor package.

8. A semiconductor packaging method comprising:
preparing a plurality of divided chips from at least one substrate structure by a dicing process;
bonding the plurality of chips to a target surface of a carrier substrate using a chip bonding apparatus, the chip bonding apparatus comprising a bonding head, the bonding head comprising a plurality of chip holding units, each of which is configured to individually hold a chip, the bonding head being configured to adjust an interval between the plurality of chip holding units, and bonding the chips to the target surface at controlled intervals using the plurality of chip holding units according to a multi-chip bonding method;
forming a molding layer configured to cover the plurality of chips on the carrier substrate;
removing the carrier substrate from the plurality of chips and the molding layer; and
dividing a package structure comprising the plurality of chips and the molding layer into package device units.

9. The semiconductor packaging method according to claim 8, wherein
the plurality of chip holding units comprises a first group of chip holding units arranged in line in a first direction, and
the bonding head is configured to move at least one of the first group of chip holding units in a direction parallel to the first direction.

10. The semiconductor packaging method according to claim 8, wherein
the plurality of chip holding units is arranged to form a plurality of rows in a first direction and a plurality of columns in a second direction perpendicular to the first direction, and
the bonding head is configured to move at least one of the plurality of chip holding units in a direction parallel to the first direction and to move at least one of the plurality of chip holding units in a direction parallel to the second direction.

11. The semiconductor packaging method according to claim 8, wherein the bonding head comprises:
a rod type member extending in a first direction; and
a first group of chip holding units coupled to the rod type member, at least one of the first group of chip holding units being configured to be linearly movable in a direction parallel to the first direction.

12. The semiconductor packaging method according to claim 8, wherein the bonding head comprises:
first and second rod type members extending side by side in a first direction and spaced apart from each other in a second direction perpendicular to the first direction, an interval between the first and second rod type members being adjusted in the second direction;
a first group of chip holding units coupled to the first rod type member, at least one of the first group of chip holding units being configured to be linearly movable along the first rod type member in a direction parallel to the first direction; and
a second group of chip holding units coupled to the second rod type member, at least one of the second group of chip holding units being configured to be linearly movable along the second rod type member in a direction parallel to the first direction.

13. The semiconductor packaging method according to claim 8, comprising:
picking up a first group of chips, among the plurality of chips, using a pickup device comprising a pickup head;
flipping the pickup head upside down to reverse upward and downward directions of the first group of chips; and
transferring at least two of the first group of chips having the upward and downward directions reversed to the carrier substrate using the chip bonding apparatus.

14. The semiconductor packaging method according to claim 13, comprising:
adjusting an interval between the at least two chips by adjusting an interval between the plurality of chip holding units in a state in which the at least two chips are held by the plurality of chip holding units, respectively; and
bonding the at least two chips with the adjusted interval to the target surface.

15. The semiconductor packaging method according to claim 8, comprising:
picking up a first group of chips, among the plurality of chips, and disposing the first group of chips on a shuttle member using a pickup device;
flipping the shuttle member upside down such that upward and downward directions of the first group of chips are reversed and disposing the shuttle member on an intermediate transfer plate; and
transferring the first group of chips having the upward and downward directions reversed to the carrier substrate using the chip bonding apparatus.
